# EUROPEAN PATENT APPLICATION

(11) **EP 4 608 087 A1**
(43) Date of publication of application: **27.08.2025**
(21) Application number: 24211846.1
(22) Date of filing: 08.11.2024
(51) Int. Cl.: H10D 30/01, H10D 30/66, H10D 64/00, H10D 64/23, H10D 84/00

(54) **TRENCH CELL STRUCTURE HAVING SCHOTTKY BARRIERS AND PREPARATION METHOD THEREOF**

(30) Priority: 22.02.2024 CN 202410199428
(71) Applicant: Chongqing Alpha and Omega Semiconductor Limited, Chongqing 400700 (CN)
(72) Inventor: LI, JIAN WEI, Chongqing, 400700 (CN)
(74) Representative: Metida

(57) **Abstract**

A trench cell structure having Schottky barriers and a preparation method thereof are provided. The trench cell structure includes a silicon substrate. A back metal layer is disposed on a back surface of the silicon substrate. The silicon substrate is heavily doped. A body region, a dielectric layer, and a front metal layer are sequentially disposed on a front surface of the silicon substrate from bottom to top. The drift region is lightly doped. Deep trench regions and a shallow trench region are defined on the body region at intervals. The deep trench regions and the shallow trench region include shielding electrodes and ohmic contact structures. The Schottky contact barriers are disposed between the deep trench regions and the shallow trench region, which reduces anode carrier injection efficiency when the trench cell structure is forwardly conducted, reduces reverse recovery charge, and reduces a reverse recovery time.

## Description

### TECHNICAL FIELD

The present disclosure relates to a field of power semiconductors, and in particular relates to a trench cell structure having Schottky barriers and a preparation method thereof.

### BACKGROUND

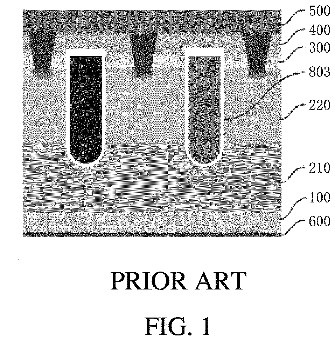

As shown in FIG. 1, a cell region of a conventional trench power device (taking an N-type trench device as an example) generally defines trenches, and source regions and ohmic contact structures are disposed between the trenches. When the N-type trench device is applied to a metal-oxide-semiconductor field-effect transistor (MOSFET) device, since the MOSFET device comprises a parasitic transistor and a gate thereof is unable to turn off a current, when the parasitic transistor is turned on, the gate is unable to turn off a current of the MOSFET. In addition, the parasitic transistor that is turned on has a negative temperature coefficient, if the MOSFET device is turned on under high temperature and large current conditions, regions with higher temperatures share more current, causing current fuses in weak units and leading to thermal runaway.

When the N-type trench device is applied to an insulated gate bipolar transistor (IGBT) device, the IGBT device has a latch-up effect, that is, there is a parasitic thyristor disposed inside the IGBT device. For N-P-N bases and emitters, there is a forward bias voltage within a specified collector current range. The forward bias voltage is generally not very large. However, when a collector current increases to a certain extent, the forward bias voltage may be too large to turn on N-P-N transistors, thereby making the N-P-N and P-N-P transistors in saturation. At this time, the parasitic thyristor is turned on, and a gate thereof lose an original control function, thus forming a self-locking phenomenon, increasing the collector current, and resulting in excessive power consumption and IGBT device failure.

The latch-up effect mainly refers to a fact that when the IGBT device turns off at high speed, the current drops too fast (di/dt is large) and dv/dt is large, causing a large displacement current, generating the forward bias voltage larger enough to turn on the N-P-N transistors, which make the parasitic thyristor to self-lock. Once a thyristor is triggered, since the thyristor do not automatically extinguish an arc due to a blocking signal of the gate, the IGBT device is unable to be turned off at this time, which eventually makes the IGBT device to be damaged due to overcurrent.

### SUMMARY

In order to solve defects in the prior art, the present disclosure provides a trench cell structure having Schottky barriers and a preparation method thereof.

To solve technical problems in the prior art, the present disclosure provides the trench cell structure having the Schottky barriers. The trench cell structure comprises a silicon substrate, a back metal layer, a drift region, a body region, a dielectric layer, and a front metal layer.

The silicon substrate is heavily doped. The silicon substrate defines a front surface and a back surface. The front surface of silicon substrate is disposed opposite to the back surface of the silicon substrate. The back metal layer is disposed on the back surface of the silicon substrate. The drift region. The body region, the dielectric layer, and the front metal layer are sequentially disposed on the front surface of the silicon substrate from bottom to top. The drift region is lightly doped. The drift region is of a first conductivity type. The body region is of a second conductivity type. Deep trench regions and a shallow trench region are defined on the body region at intervals. The deep trench regions and the shallow trench region comprise shielding electrodes and ohmic contact structures. The Schottky contact barriers are disposed between the deep trench regions and the shallow trench region.

The present disclosure further provides the preparation method of the trench cell structure having the Schottky barriers. The preparation method comprises steps S1-S8.

The step S1 comprises providing a silicon substrate having an epitaxial layer of a first conductivity type disposed on a front surface thereof and a back metal layer disposed on a back surface thereof.

The step S2 comprises forming first trench groups and second trench groups disposed at intervals on the epitaxial layer. Each of the first trench groups comprises two first trenches. The second trench group comprises two second trenches. A depth of each of the first trenches is greater than a depth of each of the second trenches.

The step S3 comprises doping on an upper portion of the epitaxial layer to form a body region and forming a drift region disposed on the epitaxial layer and below the body region. A lower end surface of the body region is higher than a bottom of each of the second trenches.

The step S4 comprises filling each of the first trenches and each of the second trenches to form shielding electrodes.

The step S5 comprises forming source regions of the first conductivity type and forming a dielectric layer on the body region. Each of the source regions is disposed between the two first trenches of each of the first trench groups.

The step S6 comprises forming first contact holes; forming a first metal layer made of a first metal material on a hole wall, lower than the dielectric layer, of each of the first contact holes; and forming hole bottom implantation regions of the second conductivity type in the body region by implantation. The first contact holes are respectively disposed between the first trenches of the first trench groups and between the two second trenches of the second trench group. A hole bottom of each of the first contact holes is lower than a lower end surface of each of the source regions. A work function of the first metal material meets a requirement for forming an ohmic contact with silicon. Each of the hole bottom implantation regions is connected to the hole bottom of a corresponding first contact hole.

The step S7 comprises forming second contact holes; and forming a second metal layer made of a second metal material on a hole wall, lower than the dielectric layer, of each of the second contact holes. Each of the second contact holes is disposed between each of the first trenches and an adjacent second trench. The second contact holes extend downwards into the body region. A work function of the second metal material meets a requirement for forming a Schottky contact with the silicon.

The step S8 comprises filling the first contact holes and the second contact holes; forming a first metal column in each of the first contact holes; forming a second metal column in each of the second contact holes; and forming a front metal layer connected to each first metal column and each second metal column on a surface of the dielectric layer.

Furthermore, the step S2 comprises steps S211-S212.

The step S211 comprises photoetching patterns of the first trenches on the epitaxial layer, and etching third trenches having a depth equal to a height difference between each of the first trenches and each of the second trenches.

The step S212 comprises photoetching patterns of the second trenches on the epitaxial layer, simultaneously etching the third trenches and positions of the patterns of the second trenches on the epitaxial layer, enabling the third trenches being etched downwards to form the first trenches, and enabling positions of the patterns of the second trenches being etched to form the second trenches.

In the present disclosure, the deep trench regions and the shallow trench region are distributed at intervals, each of the source regions is a heavily doped N+ region disposed between the two first trenches of each of the deep trench regions, and no heavily doped N+ region is formed between the two second trenches of the shallow trench region. Therefore, when the trench cell structure is under a reverse condition, a depth of lateral depletion of the drift region by the deep trench regions is deeper, and a voltage withstood by the deep trench regions is greater than a voltage withstood by the shallow trench region. Therefore, during a short-circuit test including a shutdown action and an EAS test, a PN junction in the shallow trench region is broken down first to discharge a current and release most of energy, thus preventing a parasitic transistor or a parasitic thyristor from conducting when the parasitic transistor or the parasitic thyristor is reversely blocked and improving the reliability of the trench cell structure. In addition, the Schottky barriers are disposed between the deep trench regions and the shallow trench region at intervals, which reduces anode carrier injection efficiency when the trench cell structure is forwardly conducted, reduces Qrr (reverse recovery charge), reduces a reverse recovery time of the trench cell structure , and increases a limit parameter value of di/dt (current change rate).

### BRIEF DESCRIPTION OF DRAWINGS

FIG. 1 is a schematic structural diagram of a cell region of a conventional trench power device.
FIG. 2 is a schematic structural diagram of a trench cell structure having Schottky barriers according to one embodiment of the present disclosure.
FIG. 3 is a flow chart of a preparation method of the trench cell structure according to one embodiment of the present disclosure.
FIG. 4 is a schematic structural diagram of a silicon substrate having an epitaxial layer and a back metal layer according to one embodiment of the present disclosure.
FIG. 5 is a schematic structural diagram showing that first trench groups and second trench groups are disposed on the epitaxial layer.
FIG. 6 is a schematic structural diagram showing that third trenches are formed on the epitaxial layer by photoetching.
FIG. 7 is a schematic structural diagram showing that first trenches and second trenches are formed on the epitaxial layer by photoetching.
FIG. 8 is a schematic structural diagram showing that patterns of the first trenches and patterns of the second trenches are photoetched on the epitaxial layer.
FIG. 9 is a schematic structural diagram showing that the first trenches and the second trenches are filled to form shielding electrodes.
FIG. 10 is a schematic structural diagram showing that the first trenches and the second trenches are filled to form shielding electrodes.
FIG. 11 is a schematic structural diagram showing that source regions and a dielectric layer are formed.
FIG. 12 is a schematic structural diagram of first contact holes, first metal layer, and hole bottom implantation regions.
FIG. 13 is a schematic structural diagram of second contact holes and second metal layer.

### DETAILED DESCRIPTION

It should be understood that a trench cell structure is a structure in which a plurality of deep trench regions and shallow trench regions are repeatedly arranged at intervals, and only a part of the trench cell structure is shown in the embodiment for ease of description.

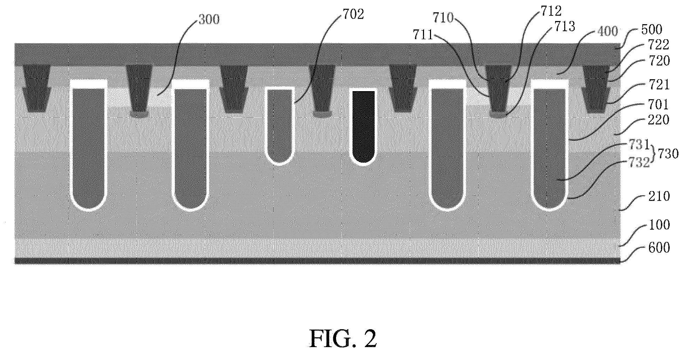

As shown in FIG. 2, FIG. 2 is a schematic structural diagram of a trench cell structure having Schottky barriers according to one embodiment of the present disclosure. The trench cell structure comprises a silicon substrate 100, a back metal layer 600, a drift region, a body region, a dielectric layer, and a front metal layer. The silicon substrate 100 is heavily doped. When the trench cell structure is used in a metal-oxide-semiconductor field-effect transistor (MOSFET) device, the silicon substrate 100 is of a first conductivity type. When the trench cell structure is used in an insulated gate bipolar transistor (IGBT) device, the silicon substrate 100 is of a second conductivity type. The first conductivity type is N type and the second conductivity type is P type.

The silicon substrate 100 defines a front surface and a back surface. The front surface of silicon substrate 100 is disposed opposite to the back surface of the silicon substrate 100. The back metal layer 600 is disposed on the back surface of the silicon substrate 100. The drift region 210, the body region 220, the dielectric layer 400, and the front metal layer 500 are sequentially disposed on the front surface of the silicon substrate 100 from bottom to top. The drift region 210 is of the first conductivity type. The body region 220 is of the second conductivity type. The drift region 210 is lightly doped, that is, the drift region 210 is an N-region.

Deep trench regions and a shallow trench region are defined on the body region 220 at intervals. The shallow trench region is disposed between the deep trench regions. The deep trench regions and the shallow trench region comprise shielding electrodes 730 and ohmic contact structures. Each of the deep trench regions defines two first trenches 701. The shallow trench region defines two second trenches 702. The first trenches 701 and the second trenches 702 penetrate downward through the body region 220 from an upper surface of the body region 220 and extend into the drift region 210. A depth of each of the first trenches 701 is greater than a depth of each of the second trench. The shielding electrodes 730 are one-to-one disposed in the first trenches 701 and the second trenches 702. The shielding electrodes 730 comprise polysilicon structures 731. The polysilicon structures 731 are respectively filled in the first trenches 701 and the second trenches 702. An outer surface of each of the polysilicon structures 731 is wrapped with an insulating oxide layer 732.

A first ohmic contact structure of the ohmic contact structures is disposed between the two first trenches 701 of each of the deep trench regions. A second ohmic contact structure of the ohmic contact structures is disposed between the two second trenches 702 of the shallow trench region.

The ohmic contact structures comprise first contact holes 710 penetrating downwards through the dielectric layer 400 from an upper surface of the dielectric layer 400 and extending into the body region 220. A first metal layer 711 is formed on a hole wall, corresponding to the body region 220, of each of the first contact holes 710. It is noted that no first metal layer 711 is formed on a hole wall, corresponding to the dielectric layer 400, of each of the first contact holes 710. Of course, in order to reduce a process difficulty, the first metal layer 711 is allowed to be formed on the hole wall, corresponding to the dielectric layer 400, of each of the first contact holes 710. Each first metal layer 711 is made of a first metal material. A work function of the first metal material meets a requirement for forming an ohmic contact with silicon. For instance, the first metal material is Ti or TiN. A first metal column 712 is disposed in each of the first contact holes 710. Each first metal layer 711 is connected to the front metal layer 500 through a corresponding first metal column 712. The body region 220 comprises hole bottom implantation regions 713. The hole bottom implantation regions 713 are of the second conductivity type. The hole bottom implantation regions 713 are heavily doped, that is, the hole bottom implantation regions 713 are P+ regions. Each of the hole bottom implantation regions 713 is connected to a hole bottom of a corresponding first contact hole 710. Source regions 300 are disposed on an upper portion of the body region 220. Each of the source regions 300 is disposed corresponding to the two first trenches 701 of each of the deep trench regions. The source regions 300 are heavily doped and are of the first conductivity type. That is, the source regions 300 are N+ regions. The hole bottom of each of the first contact holes 710 is lower than a lower end surface of each of the source regions 300.

The Schottky contact barriers are disposed between each adjacent first trench 701 and second trench 702 (i.e., the Schottky contact barriers are disposed between the deep trench regions and the shallow trench region). The Schottky contact barriers comprise second contact holes 720 penetrating downwards through the dielectric layer 400 from the upper surface of the dielectric layer 400 and extending into the body region 220. A second metal layer 721 is formed on a hole wall, corresponding to the body region 220, of each of the second contact holes720.It is noted that no second metal layer 721 is formed on a hole wall, corresponding to the dielectric layer 400, of each of the second contact holes 720. Of course, in order to reduce a process difficulty, the second metal layer 721 is allowed to be formed on the hole wall, corresponding to the dielectric layer 400, of each of the second contact holes 720. Each second metal layer 721 is made of a second metal material. A work function of the second metal material meets a requirement for forming a Schottky contact with the silicon. For instance, the second metal material is Ni, Pt or NiPt alloy. A second metal column 722 is disposed in each of the second contact holes 720. Each second metal layer 721 is connected to the front metal layer 500 through a corresponding second metal column 722.

In the present disclosure, the first trenches 701 that re deep and the second trenches that are shallow are distributed at intervals, each of the source regions 300 is a heavily doped N+ region disposed between the two first trenches 701 of each of the deep trench regions, and no heavily doped N+ region is formed between the two second trenches 702 of the shallow trench region. Therefore, when the trench cell structure is under a reverse condition, a depth of lateral depletion of the drift region 210 by the first trenches 701 is deeper, and a voltage withstood by the first trenches is greater than a voltage withstood by the second trenches 702. Therefore, during a short-circuit test including a shutdown action and an EAS test, a PN junction in the second trenches 702 is broken down first to discharge a current and release most of energy, thus preventing a parasitic transistor or a parasitic thyristor from conducting when the parasitic transistor or the parasitic thyristor is reversely blocked. improving the reliability of the trench cell structure. In addition, the Schottky barriers are disposed between the first trenches 701 and the second trenches at intervals, which reduces anode carrier injection efficiency when the trench cell structure is forwardly conducted, reduces Qrr (reverse recovery charge), reduces a reverse recovery time of the trench cell structure , and increases a limit parameter value of di/dt.

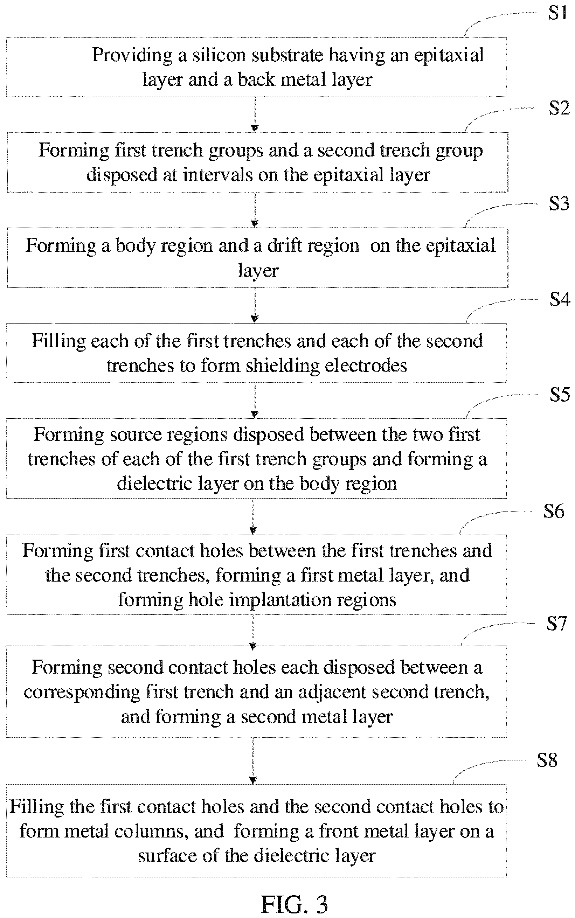

As shown in FIG. 3, FIG. 3 is a flow chart of a preparation method of a trench cell structure having Schottky barriers according to one embodiment of the present disclosure. The preparation method comprises steps S1-S8.

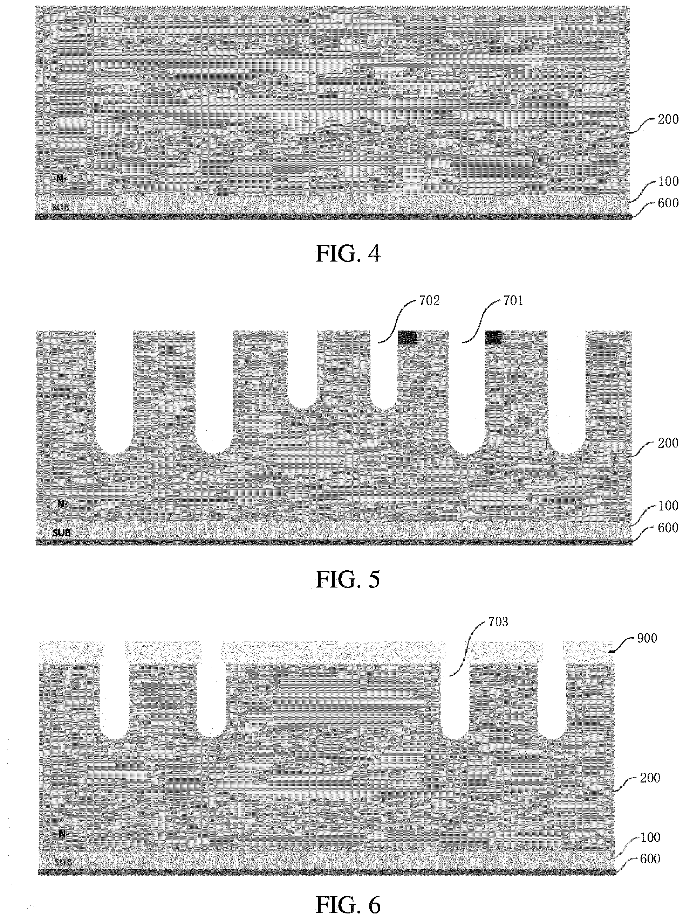

As shown in FIG. 4, the step S1 comprises providing a silicon substrate 100 having an epitaxial layer 200 disposed on a front surface thereof and a back metal layer 600 disposed on a back surface thereof. The epitaxial layer 200 is N-type. The silicon substrate 100 is heavily doped, and the epitaxial layer 200 is lightly doped. When the trench cell structure is used in the MOSFET device, the silicon substrate 100 is of an N-type substrate. When the trench cell structure is used in an IGBT device, the silicon substrate 100 is of a P-type substrate.

As shown in FIG. 5, the step S2 comprises forming first trench groups and second trench groups disposed at intervals on the epitaxial layer 200. Each of the first trench groups comprises two first trenches 701. The second trench group comprises two second trenches 702. A depth of each of the first trenches 701 is greater than a depth of each of the second trenches 702. In the step S2, two methods are adopted to form the first trenches and the second trenches. A first method thereof comprises steps S211-S212.

As shown in FIIG. 6, the step S211 comprises photoetching patterns of the first trenches 701 on the epitaxial layer 200 through photoresist 900, and etching third trenches 703 having a depth equal to a height difference between each of the first trenches 701 and each of the second trenches 702.

As shown in FIIG. 7, the step S212 comprises photoetching patterns of the second trenches 702 on the epitaxial layer 200, simultaneously etching the third trenches 703 and positions of the patterns of the second trenches 702 on the epitaxial layer 200 according to a depth design of the third trenches in the step S211, enabling the third trenches being etched downwards to form the first trenches 701, and enabling positions of the patterns of the second trenches 702 being etched to form the second trenches 702.

A second method of forming the first trench groups and the second trench group comprises steps S221-S222.

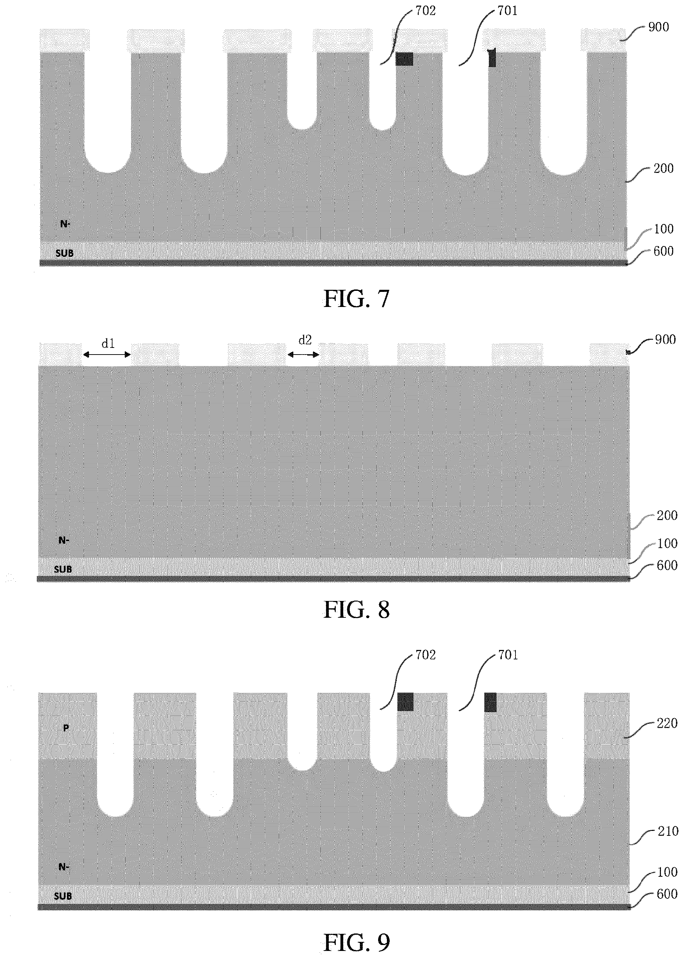

As shown in FIG. 8, the step S221 comprises photoetching patterns of the first trenches 701 and patterns of the second trenches 702 on the epitaxial layer 200. A width of each of the patterns of the first trenches 701 and a width of each of the patterns of the second trenches 702 are respectively determined according to a predetermined depth of each of the first trenches 701 and a predetermined depth of each of the second trenches 702. The predetermined depth of each of the first trenches 701 is greater than a predetermined depth of each of the second trenches 702, so that the width d1 of each of the patterns of the first trenches 701 is greater than a width d2 of each of the patterns of the second trenches 702.

The step S222 comprises simultaneously etching the patterns of the first trenches 701 and the patterns of the second trenches 702 to form the first trenches 701 and the second trenches 702. By designing the width d1 of each of the patterns of the first trenches 701 and the width d2 of each of the patterns of the second trenches 702 in the step S221, the first trench 701 is etched to a predetermined depth of the first trench 701 At the same time, the second trench 702 is also etched to a predetermined depth of the second trench 702. Thus, the first trenches 701 and the second trenches 702 are simultaneously formed through one etching.

As shown in FIG. 9, the step S3 comprises doping on an upper portion of the epitaxial layer 200 to form a body region 220 and forming a drift region 210 disposed on the epitaxial layer 200 and below the body region 220. The body region 220 is of the P type. A lower end surface of the body region 220 is higher than a bottom of each of the second trenches 702, so that the first trenches 701 and the second trenches 702 penetrate through the body region 220.

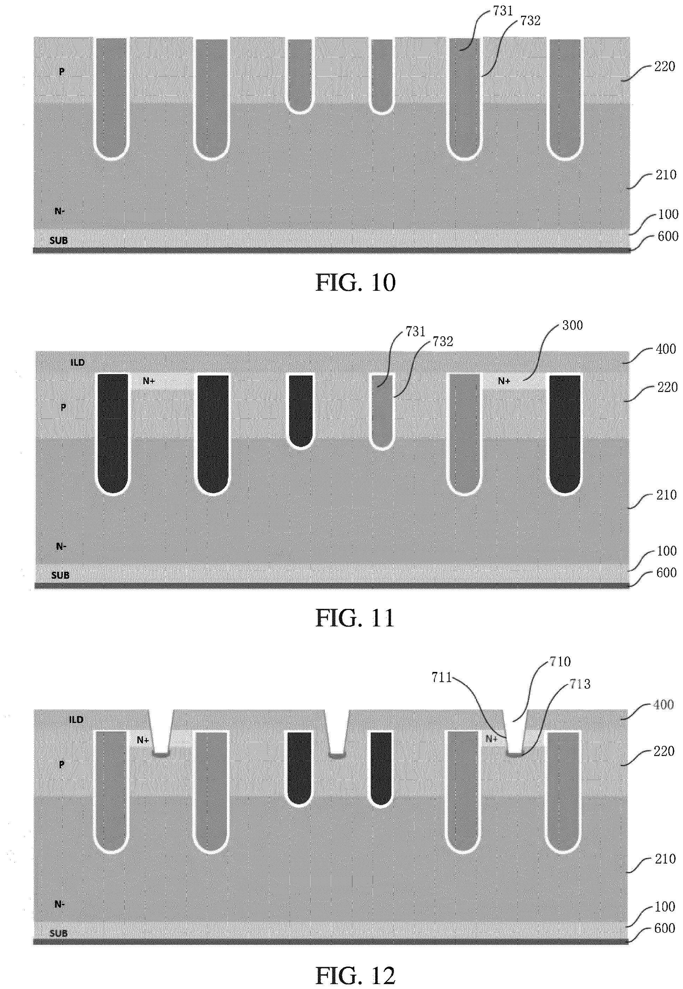

As shown in FIG. 10, the step S4 comprises filling each of the first trenches 701 and each of the second trenches 702 to form shielding electrodes 730. The shielding electrodes 730 comprise polysilicon structures 731 and insulating oxide layer 732. The polysilicon structures 731 are respectively filled in the first trenches 701 and the second trenches 702. An outer surface of each of the polysilicon structures 731 is wrapped with a corresponding insulating oxide layer 732.

As shown in FIG. 11, the step S5 comprises forming source regions 300 of the N type and forming a dielectric layer 400 on the body region 220. Each of the source regions 300 is heavily doped and is disposed between the two first trenches 701 of each of the first trench groups.

As shown in FIG. 12, the step S6 comprises forming first contact holes 710; forming a first metal layer 711 made of a first metal material on a hole wall, lower than the dielectric layer 400, of each of the first contact holes 710; and forming hole bottom implantation regions 713 of the p type in the body region 220 through implantation. The first contact holes 710 are respectively disposed between the first trenches 701 of the first trench groups and between the two second trenches 702 of the second trench group. A hole bottom of each of the first contact holes 710 is lower than a lower end surface of each of the source regions. It is noted that no first metal layer 711 is formed on a hole wall, corresponding to the dielectric layer 400, of each of the first contact holes 710. Of course, in order to reduce a process difficulty, the first metal layer 711 is allowed to be formed on the hole wall, corresponding to the dielectric layer 400, of each of the first contact holes 710. Each first metal layer 711 is made of a first metal material. A work function of the first metal material meets a requirement for forming an ohmic contact with silicon. For instance, the first metal material is Ti or TiN. The hole bottom implantation regions 713 are heavily doped. Each of the hole bottom implantation regions 713 is connected to a hole bottom of a corresponding first contact hole 710.

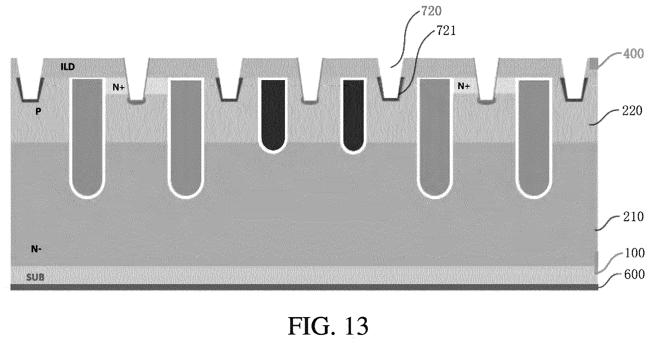

As shown in FIG. 13, the step S7 comprises forming second contact holes 720; forming a second metal layer 721 made of a second metal material on a hole wall, lower than the dielectric layer 400, of each of the second contact holes 720. Each of the second contact holes is disposed between each of the first trenches 701 and an adjacent second trench. The second contact holes extend downwards into the body region 220. It is noted that no second metal layer 721 is formed on a hole wall, corresponding to the dielectric layer 400, of each of the second contact holes 720. Of course, in order to reduce a process difficulty, the second metal layer 721 is allowed to be formed on the hole wall, corresponding to the dielectric layer 400, of each of the second contact holes 720. Each second metal layer 721 is made of a second metal material. A work function of the second metal material meets a requirement for forming a Schottky contact with the silicon. For instance, the second metal material is Ni, Pt or NiPt alloy.

As shown in FIG. 2, the step S8 comprises filling the first contact holes 710 and the second contact holes, forming a first metal column 712 in each of the first contact holes 710, and forming a second metal column 722 in each of the second contact holes 722; forming a front metal layer 500 connected to each first metal column and each second metal column on a surface of the dielectric layer 400.

In the present disclosure, the deep trench regions and the shallow trench region are distributed at intervals, each of the source regions 300 is the heavily doped N+ region disposed between the two first trenches 701 of each of the deep trench regions, and no heavily doped N+ region is formed between the two second trenches of the shallow trench region. Therefore, when the trench cell structure is under the reverse condition, the parasitic transistor or the parasitic thyristor is prevented from conducting when the parasitic transistor or the parasitic thyristor is reversely blocked. improving the reliability of the trench cell structure. In addition, the Schottky barriers are disposed between the deep trench regions and the shallow trench region at intervals, which reduces the anode carrier injection efficiency when the trench cell structure is forwardly conducted, reduces the Qrr, reduces the reverse recovery time of the trench cell structure, and increases the limit parameter value of di/dt .

## Claims

1. A trench cell structure having Schottky barriers, comprising:
a silicon substrate,
a back metal layer,
a drift region,
a body region,
a dielectric layer, and
a front metal layer;
wherein the silicon substrate is heavily doped; the silicon substrate defines a front surface and a back surface; the front surface of silicon substrate is disposed opposite to the back surface of the silicon substrate; the back metal layer is disposed on the back surface of the silicon substrate; the drift region, the body region, the dielectric layer, and the front metal layer are sequentially disposed on the front surface of the silicon substrate from bottom to top; the drift region is lightly doped; the drift region is of a first conductivity type; the body region is of a second conductivity type; deep trench regions and a shallow trench region are defined on the body region at intervals; the deep trench regions and the shallow trench region comprise shielding electrodes and ohmic contact structures; the Schottky contact barriers are disposed between the deep trench regions and the shallow trench region.

2. The trench cell structure according to claim 1, wherein each of the deep trench regions defines two first trenches; the shallow trench region defines two second trenches; the first trenches and the second trenches penetrate downward through the body region from an upper surface of the body region and extend into the drift region; a depth of each of the first trenches is greater than a depth of each of the second trench; the shielding electrodes are one-to-one disposed in the first trenches and the second trenches; a first ohmic contact structure of the ohmic contact structures is disposed between the two first trenches of each of the deep trench regions; a second ohmic contact structure of the ohmic contact structures is disposed between the two second trenches of the shallow trench region.

3. The trench cell structure according to claim 2, wherein the shielding electrodes comprise polysilicon structures; the polysilicon structures are respectively filled in the first trenches and the second trenches; an outer surface of each of the polysilicon structures is wrapped with an insulating oxide layer.

4. The trench cell structure according to claim 1, wherein the ohmic contact structures comprise first contact holes penetrating downwards through the dielectric layer from an upper surface of the dielectric layer and extending into the body region; a first metal layer is formed on a hole wall, corresponding to the body region, of each of the first contact holes; each first metal layer is made of a first metal material; a work function of the first metal material meets a requirement for forming an ohmic contact with silicon; a first metal column is disposed in each of the first contact holes; each first metal layer is connected to the front metal layer through a corresponding first metal column; the body region comprises hole bottom implantation regions; the hole bottom implantation regions are of the second conductivity type; each of the hole bottom implantation regions is connected to a hole bottom of a corresponding first contact hole; the hole bottom implantation regions are heavily doped; source regions are disposed on an upper portion of the body region; each of the source regions is disposed corresponding to the two first trenches of each of the deep trench regions; the source regions are heavily doped and are of the first conductivity type; the hole bottom of each of the first contact holes is lower than a lower end surface of each of the source regions.

5. The trench cell structure according to claim 4, wherein the Schottky contact barriers comprise second contact holes penetrating downwards through the dielectric layer from the upper surface of the dielectric layer and extending into the body region; a second metal layer is formed on a hole wall, corresponding to the body region, of each of the second contact holes; each second metal layer is made of a second metal material; a work function of the second metal material meets a requirement for forming a Schottky contact with the silicon; a second metal column is disposed in each of the second contact holes; each second metal layer is connected to the front metal layer through a corresponding second metal column.

6. The trench cell structure according to any one of claims 1-5, wherein the first conductivity type is N type, and the second conductivity type is P type.

7. The trench cell structure according to claim 6, wherein when the trench cell structure is used in a metal-oxide-semiconductor field-effect transistor (MOSFET) device, the silicon substrate is of the first conductivity type; when the trench cell structure is used in an insulated gate bipolar transistor (IGBT) device, the silicon substrate is of the second conductivity type.

8. A preparation method of a trench cell structure having Schottky barriers, comprising:
a step S1: providing a silicon substrate having an epitaxial layer disposed on a front surface thereof and a back metal layer disposed on a back surface thereof; wherein the epitaxial layer is of a first conductivity type;
a step S2: forming first trench groups and a second trench group disposed at intervals on the epitaxial layer; wherein each of the first trench groups comprises two first trenches; the second trench group comprises two second trenches; a depth of each of the first trenches is greater than a depth of each of the second trenches;
a step S3: doping on an upper portion of the epitaxial layer to form a body region of a second conductivity type and forming a drift region disposed on the epitaxial layer and below the body region; wherein a lower end surface of the body region is higher than a bottom of each of the second trenches;
a step S4: filling each of the first trenches and each of the second trenches to form shielding electrodes;
a step S5: forming source regions of the first conductivity type and forming a dielectric layer on the body region; wherein each of the source regions is disposed between the two first trenches of each of the first trench groups,
a step S6: forming first contact holes; forming a first metal layer made of a first metal material on a hole wall, lower than the dielectric layer, of each of the first contact holes; and forming hole bottom implantation regions of the second conductivity type in the body region by implantation; wherein the first contact holes are respectively disposed between the first trenches of the first trench groups and between the two second trenches of the second trench group; a hole bottom of each of the first contact holes is lower than a lower end surface of each of the source regions; a work function of the first metal material meets a requirement for forming an ohmic contact with silicon; each of the hole bottom implantation regions is connected to the hole bottom of a corresponding first contact hole;
a step S7: forming second contact holes; forming a second metal layer made of a second metal material on a hole wall, lower than the dielectric layer, of each of the second contact holes; wherein each of the second contact holes is disposed between each of the first trenches and an adjacent second trench; the second contact holes extend downwards into the body region; a work function of the second metal material meets a requirement for forming a Schottky contact with the silicon; and
a step S8: filling the first contact holes and the second contact holes; forming a first metal column in each of the first contact holes; forming a second metal column in each of the second contact holes; and forming a front metal layer connected to each first metal column and each second metal column on a surface of the dielectric layer.

9. The preparation method according to claim 8, wherein the step S2 comprises:
a step S211: photoetching patterns of the first trenches on the epitaxial layer, and etching third trenches having a depth equal to a height difference between each of the first trenches and each of the second trenches; and
a step S212: photoetching patterns of the second trenches on the epitaxial layer, simultaneously etching the third trenches and positions of the patterns of the second trenches on the epitaxial layer, enabling the third trenches being etched downwards to form the first trenches and enabling positions of the patterns of the second trenches being etched to form the second trenches.

10. The preparation method according to claim 8, wherein the step S2 comprises:
a step S221: photoetching patterns of the first trenches and patterns of the second trenches on the epitaxial layer; wherein a width of each of the patterns of the first trenches and a width of each of the patterns of the second trenches are respectively determined according to a predetermined depth of each of the first trenches and a predetermined depth of each of the second trenches, so that the width of each of the patterns of the first trenches is greater than a width of each of the patterns of the second trenches; and
a step S222: simultaneously etching the patterns of the first trenches and the patterns of the second trenches to form the first trenches and the second trenches.
